**Europäisches Patentamt**

**European Patent Office**

**Office européen des brevets**

(19)

(11) Veröffentlichungsnummer : **0 049 392**
**B1**

(12) **EUROPÄISCHE PATENTSCHRIFT**

(45) Veröffentlichungstag der Patentschrift :
27.07.88

(51) Int. Cl.⁴ : **H 01 L 21/82, H 01 L 27/08, H 01 L 21/316, H 01 L 29/60**

(21) Anmeldenummer : 81107333.7

(22) Anmeldetag : 16.09.81

(54) Verfahren zum Herstellen einer monolithisch integrierten Zwei-Transistor-Speicherzelle in MOS-Technik.

(30) Priorität : 06.10.80 DE 3037744

(43) Veröffentlichungstag der Anmeldung :
14.04.82 Patentblatt 82/15

(45) Bekanntmachung des Hinweises auf die Patenterteilung : 27.07.88 Patentblatt 88/30

(84) Benannte Vertragsstaaten :
DE FR GB IT

(56) Entgegenhaltungen :
EP-A- 0 016 386
FR-A- 2 330 146
IEEE JOURNAL OF SOLID-STATE CIRCUITS, Band SC-15, Nr. 3, Juni 1980, Seiten 353-357, New York, US,
A.SCHEIBE et al.: "A two-transistor SIMOS EAROM cell"
IEEE Transactions on Electron Devices, Vol. ED-24, Mai 1977, Seiten 600-606

(73) Patentinhaber : Siemens Aktiengesellschaft Berlin und München
Wittelsbacherplatz 2
D-8000 München 2 (DE)

(72) Erfinder : Scheibe, Adolf, Dr., Dipl.-Phys.
Finkenstrasse 9a
D-8012 Ottobrunn (DE)

EP 0 049 392 B1

## Beschreibung

Verfahren zum Herstellen einer monolithisch integrierten Zwei-Transistor-Speicherzelle in MOS-Technik.

Die Erfindung betrifft ein Verfahren zum Herstellen einer monolithisch integrierten Zwei-Transistor-Speicherzelle nach dem Oberbegriff des Patentanspruches 1.

Ein gattungsgemäßes Verfahren ist aus « IEEE Journal of solid-state circuits », Vol. SC-15 (1980) June, No. 3, Seiten 353 bis 357 herleitbar.

Ein ähnliches Verfahren ist aus der Literaturstelle « IEEE Trans. Electron. Devices » Vol. ED-24, pp. 600-606 (May 1977), bekannt. Dabei wird der der einzelnen Speicherzelle zugeteilte Bereich der Oberfläche des aus monokristallinem, insbesondere p-leitendem Silicium bestehenden Substrats mit einer Gateoxydschicht durch thermische Oxydation abgedeckt. Dann wird auf der Gateoxydschicht eine Schicht aus dotiertem polykristallinem Silicium abgeschieden, die die Grundlage des schwebenden Gates des ersten MOS-Feldeffekttransistors und ggf. auch des Steuergates des zweiten MOS-Feldeffekttransistors bildet. Diese erste polykristalline Siliciumschicht wird dann — wenigstens am Ort des späteren schwebenden Gates des ersten MOS-Feldeffekttransistors — erneut mit einer Oxydschicht abgedeckt, die dann die Unterlage für eine zweite dotierte polykristalline Siliciumschicht bildet.

Aus der zweiten polykristallinen Siliciumschicht wird dann das Steuergate des ersten MOS-Feldeffekttransistors unter Anwendung einer Photolack-Ätztechnik gestaltet. Falls am Ort für das Steuergate des zweiten MOS-Feldeffekttransistors die erste polykristalline Siliciumschicht vorher bei einer provisorischen Formung des schwebenden Gates von der sie tragenden Gateoxydschicht weggeätzt worden ist, wird man den dann auf dem Gateoxyd für den zweiten Transistor abgeschiedenen Teil der zweiten polykristallinen Siliciumschicht zu dem Steuergate des zweiten MOS-Feldeffekttransistors weiterverarbeiten. Andererseits kann man aber auch das Steuergate für den zweiten Transistor aus der ersten polykristallinen Siliciumschicht formen, so daß die zweite polykristalline Siliciumschicht am Ort des zweiten Transistors nicht benötigt wird und deshalb von der das Steuergate des zweiten MOS-Feldeffekttransistors abdeckenden Oxydschicht in bekannter Weise wieder abgeätzt wird.

Im Interesse einer günstigen und definierten Löschfunktion bei Abänderung des in der betreffenden Speicherzelle gespeicherten Informationsgehaltes wäre es vorteilhaft, wenn das die schwebende Gateelektrode des ersten MOS-Feldeffekttransistors der Speicherzelle tragende Oxyd im Löschbereich in definierter Weise dünner als im Kanalbereich des ersten MOS-Feldeffekttransistors eingestellt wird. Beispielsweise könnte man dies durch lokalisiertes Dünnätzen des auf die normale Stärke des Gateoxyds eingestellten ersten Oxyds am Ort des beabsichtigten Löschbereiches erreichen. Es hat sich jedoch gezeigt, daß diese Möglichkeit besser durch die von der Erfindung vorgeschlagene Möglichkeit zu ersetzen ist, da dann die Dicke des den Löschbereich an der Siliciumoberfläche bedeckenden Oxyds merklich besser reproduzierbar wird.

Die Aufgabe wird bei dem gattungsgemäßen Verfahren durch die kennzeichnenden Merkmale des Patentanspruches 1 gelöst.

Vorteilhafte Aus- und Weiterbildungen sind in Unteransprüchen gekennzeichnet.

Da man im allgemeinen an der Oberfläche des Siliciumkristalls eine Vielzahl von zu einer Matrix vereinigten Speicherzellen in gemeinsamen Fertigungsprozessen erzeugt und man an einer möglichst dichten Anordnung der Speicherzellen interessiert ist und weil andererseits für den Betrieb der Speicherzellen eine möglichst gute Isolation zwischen benachbarten Speicherzellen notwendig ist, pflegt man vor der Herstellung der Speicherzellen das für die Gesamtheit dieser Speicherzellen vorgesehene Areal an der Oberfläche des scheibenförmigen und insbesondere p-dotierten Siliciumeinkristalls durch entsprechend lokalisierte Oxydation : in einander gleiche Bereiche zu unterteilen und in jedem der auf diese Weise erhaltenen und von einer rahmenförmigen dickeren Oxydschicht Dox umgebenen Bereiche je eine Zwei-Transistor-Speicherzelle herzustellen. Diese Isolationsmethode wird zweckmäßig auch bei dem erfindungsgemäßen Verfahren mit angewendet.

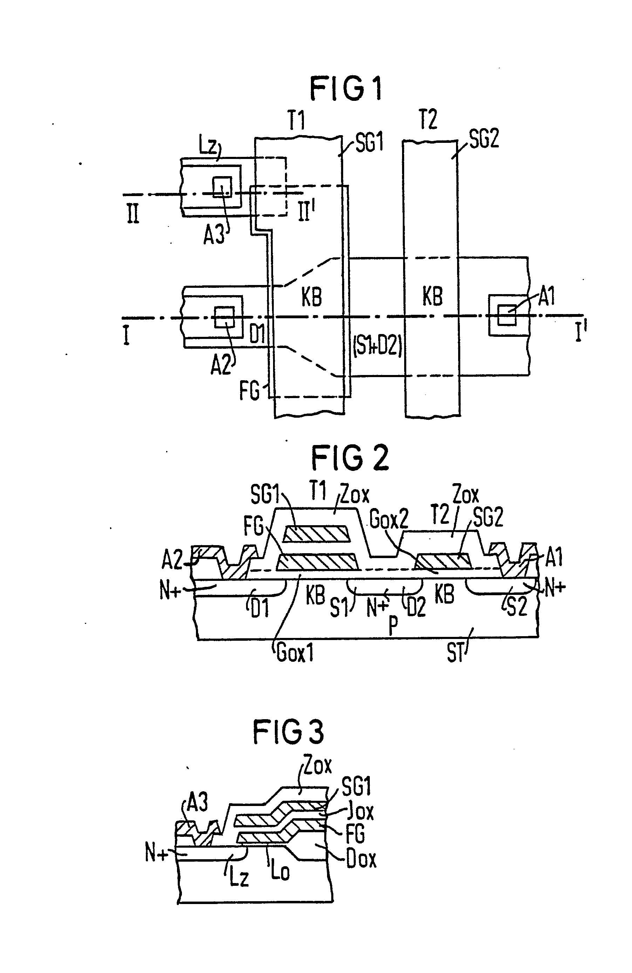

Die Erfindung wird nun anhand der Figuren 1-5 und 6a-10b näher beschrieben. Dabei ist in Fig. 1 bis 3 der Aufbau der herzustellenden Zwei-Transistor-Speicherzelle und in den übrigen Figuren die von der Erfindung vorgeschlagene Herstellungsweise dargestellt.

Bei der anhand der Figuren 1 bis 3 dargestellten Zwei-Transistor-Speicherzelle handelt es sich um die Kombination eines der Adressierung der betreffenden Speicherzelle dienenden Auswahl-Transistors — also dem zweiten MOS-Feldeffekttransistor T2 gemäß Definition der Erfindung — mit einem — den ersten MOS-Feldeffekttransistor T1 darstellenden — MOS-EEPROM-Speichertransistor. Der erste MOS-Feldeffekttransistor T1 hat dementsprechend zwei übereinander angeordnete Polysilicium-Gates, nämlich das schwebende Gate (oder floating gate) FG und das Steuergate SG1. Der zweite MOS-Feldeffekttransistor T2 der Speicherzelle hat demgegenüber nur ein Gate, nämlich das Steuergate SG2. Wesentlich ist außerdem, daß sich das schwebende Gate FG und das Steuergate SG1 des ersten Transistors T1 nicht nur im Kanalbereich KB des ersten Transistors T1 sondern auch in dem abseits des Kanalbereichs KB anzuordnenden Löschbereich Überlappen, wie dies aus Fig. 3 ersichtlich ist. Der Löschbereich ist als diejenige Stelle an der Oberfläche des Siliciumkristalls im Bereich der einzelnen Speicherzelle definiert, an der bei Löschung die in der betreffenden Speicherzelle enthaltende und dem Pegel « 1 » entsprechende elektrische Ladung des schwebenden Gates zum Verschwinden gebracht wird. Zu diesem Zweck ist, wie aus Fig. 2 und Fig. 3 ersichtlich, im Löschbereich an der Siliciumoberfläche ein $N^+$-dotiertes Diffusionsgebiet LZ vorgesehen. Dieses Diffusionsgebiet LZ ist durch eine dünne, d. h. 20-30 nm dicke $SiO_2$-Schicht, das sog. Löschoxyd Lo, von der Siliciumoberfläche am Diffusionsgebiet LZ abgedeckt. Demgegenüber ist die Stärke der das schwebende Gate FG des ersten Transistors T1 und der das Steuergate SG2 des zweiten Transistors tragenden Oxydschichten Gox1 und Gox2 abseits vom Diffusionsgebiet LZ wesentlich größer und beträgt i. a. 100-120 nm.

Die Programmierung der Speicherzelle erfolgt mittels Kanalinjektion im Kanalbereich KB des ersten MOS-Feldeffekttransistors T1. Für die Löschung wird der sog. Fowler-Nordheim-Effekt ausgenutzt, bei dem ein Tunnelstrom zwischen dem schwebenden Gate FG und der Diffusionszone LZ im Löschbereich der Zelle erzeugt wird, der das dünne Löschoxyd Lo aufgrund einer 20-30 V betragenden und zwischen das Steuergate SG1 des ersten Transistors T1 und dem sperrfreien Anschluß A3 des Löschdiffusionsgebietes LZ zu legenden Löschspannung überwindet, ohne dieses merklich zu beeinträchtigen.

Der erste MOS-Feldeffekttransistor T1 hat eine als Drain dienende $N^+$-dotierte Diffusions-und/oder Implantationszone D1 und eine in einem den Kanalbereich KB des ersten Transistors T1 definierenden Abstand erzeugte und ebenfalls $N^+$-dotierte Sourcezone S1, die bevorzugt mit dem Drain D2 des zweiten MOS-Feldeffekttransistors T2 im Interesse der Vereinfachung und Verminderung des Platzbedarfs der Zelle zu einer gemeinsamen $N^+$-Zone zusammengefaßt ist. Die Sourcezone S2 des zweiten Transistors T2 ist ebenfalls $N^+$-dotiert, während das Kanalgebiet KB des ersten Transistors T1 und das Kanalgebiet KB des zweiten Transistors T2 p-leitend und z. B. durch je einen nicht umdotierten Bereich des p-dotierten Substrats ST gegeben ist.

Die Isolation an der Oberfläche der Speicherzelle weist außer den bereits genannten und das Gateoxyd Gox bzw. das Löschoxyd Lo bildenden Teilen noch das sich zwischen das schwebende Gate FG des ersten Transistors T1 und dessen Steuergate SG1 einschiebende Isolationsoxyd Jox sowie eine z. B. ebenfalls aus $SiO_2$ bestehende Schicht Zox auf. Schließlich ist noch an das bereits erwähnte und der Abgrenzung des der betreffenden Speicherzelle zugeteilten Bereichs an der Siliciumoberfläche dienende Rahmenoxyd Dox (üblich ist die Bezeichnung « Feldoxyd ») zu erinnern.

Ersichtlich ist in Fig. 1 die herzustellende Zwei-Transistorzelle in Aufsicht, also im Layout dargestellt, während Fig. 2 den entlang der aus Fig. 1 ersichtlichen Linie I-I' geführten Schnitt und Fig. 3 den längs der ebenfalls aus Fig. 1 ersichtlichen Linie II-II' geführten Schnitt darstellt.

Das erfindungsgemäße Verfahren geht zweckmäßig von einem p-dotierten monokristallinen scheibenförmigen Siliciumkörper, dem Substrat ST aus, dessen zu bearbeitende Oberfläche (100)-orientiert ist. Gegebenfalls kann die zu bearbeitende Oberfläche auch die Oberfläche einer epitaktisch auf einem n-dotierten Siliciumeinkristall abgeschiedenen p-dotierten Siliciumschicht sein. Die Konzentration der insbesondere aus Bor bestehenden Dotierung des Substrats ST ist auf einen Widerstandswert von 8-10 Ohm · cm eingestellt.

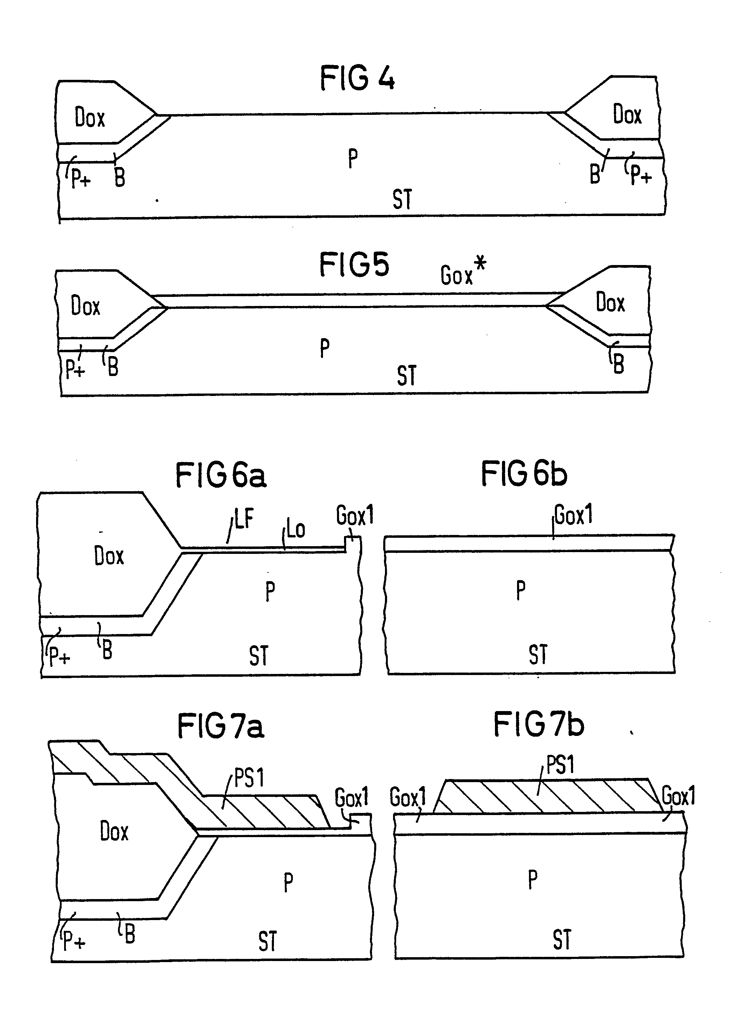

Vor der Durchführung des erfindungsgemäßen Verfahrens wird die (100)-orientierte Substratoberfläche in die den einzelnen Speicherzellen zugeteilten Bereiche durch Erzeugung des die einzelnen Bereiche rahmenförmig umgebenden Feldoxyds Dox unterteilt. Zweckmäßig wird hierzu an der Substratoberfläche zunächst eine etwa 10 nm dicke Oxydschicht erzeugt und mit einer Siliciumnitridschicht von etwa 160 nm Stärke abgedeckt. Mittels Photolack-Ätztechnik werden, z. B. unter Verwendung des Plasma-Ätzverfahrens — die mit dem Feldoxyd Dox zu versehenden Stellen der Substratoberfläche freigelegt, während die von den noch zu erzeugenden Speicherzellen einzunehmenden und von dem Feldoxydrahmen jeweils umgebenen Bereiche der Substratoberfläche zunächst von der 10 nm starken Oxydschicht und der als Oxydationsmaske dienenden Siliciumnitridschicht bedeckt bleiben. An den freigelegten Stellen der Substratoberfläche wird zunächst durch Implantation von Borionen die Substratdotierung lokal erhöht. Dann wird die Erzeugung des Feldoxyds an den durch die Borimplantation vorbehandelten Stellen der Substratoberfläche vorgenommen. Die Stärke des Feldoxyds Dox wird beispielsweise auf 1,6 $\mu$m eingestellt. Schließlich wird die Nitridschicht, z. B. durch Ätzung mit heißer Phosphorsäure oder Plasmaätzung, entfernt. Die als Träger der aus Siliciumnitrid bestehenden Oxydationsmaske verwendete Oxydschicht kann ggf. als Grundlage für das Gateoxyd erhalten bleiben. In vielen Fällen wird man jedoch nach der Erzeugung des Feldoxyds nicht nur die Nitrid-Oxydationsmaske sondern auch die sie tragende Oxydschicht von der Siliciumoberfläche entfernen, so daß man den aus Fig. 4 ersichtlichen Ausgangszustand hat. Fig. 4 zeigt den längs des Schnittes I-I' der gemäß Fig. 1 zu erzeugenden Speicherzelle. Unterhalb der Streifen Dox aus dem Feldoxyd hat man infolge der Bor-Implantation mit Bor angereicherte Zonen B, die bekanntlich als Channelstopper wirken.

Das beschriebene Verfahren zur Herstellung des Feldoxyds Dox wird angewendet, um eine Verkleinerung der Strukturgröße und eine Reduzierung der Anzahl der insgesamt erforderlichen Photolackmasken zu erreichen. Außerdem erhält man, wie bereits bemerkt, eine bessere gegenseitige Isolation der Speicherzellen. Der in Fig. 4 dargestellte Schnitt entspricht der Linie I-I' gemäß Fig. 1 der herzustellenden Zwei-Transistor-Speicherzelle.

In dem nun folgenden ersten Oxidationsprozeß des eigentlichen erfindungsgemäßen Verfahrens wird die nunmehr in den einzelnen zur Herstellung je einer Speicherzelle vorgesehenen Bereichen freiliegende Oberfläche des Substrats ST mit einer die Grundlage des Gateoxyds Gox1 am Ort des herzustellenden Transistors T1 bildenden ersten Oxydschicht Gox* bedeckt. Dabei wird die Stärke dieser ersten Oxydschicht Gox* derart eingestellt, daß ihre Summe mit der Stärke des vorgesehenen Löschoxyds genau die für das Gateoxyd Gox1 am Ort des ersten Transistors T1 vorgesehene Stärke ergibt. Der nunmehr erreichte Zustand längs der Linie I-I' ist in Figur 5 dargestellt.

Der nun folgende Schritt zur Erzeugung des Löschfensters LF in der durch den ersten Oxidationsschritt erhaltenen Oxydschicht Gox* beschränkt sich ausschließlich auf den für die jeweilige Speicherzelle vorgesehenen Löschbereich. Dabei wird, wie aus Fig. 6a ersichtlich, das Feldoxyd Dox als ein Teil der Begrenzung des Löschfensters LF benutzt. Das Löschfenster LF wird in üblicher Weise durch Photolack-Ätztechnik hergestellt, so daß sich weitere Ausführungen darüber erübrigen. Da der Schnitt I-I' durch das herzustellende Layout gemäß Fig. 1 den Löschbereich der Speicherzelle nicht berührt und da das Löschfenster LF abseits der Kanalgebiete KB der beiden Transistoren T1 und T2 der Speicherzelle erzeugt werden soll, wird in Fig. 6 und in den folgenden Figuren der jeweils im Löschbereich, also längs des Schnittes II-II' in Fig. 1 erreichte Fertigungszustand in dem Teil a der betreffenden Figur und der in den Kanalbereichen KB der beiden Transistoren T1 und T2, also längs des Schnittes I-I' erreichte Zustand im Teil b der betreffenden Figur dargestellt. Dem entspricht, daß das Löschfenster LF nur aus Fig. 6a, nicht aber aus Fig. 6b ersichtlich ist.

Die nach Erzeugung des zur Substratoberfläche durchgehenden Löschfensters LF erhaltene Anordnung wird nun dem zweiten Oxidationsprozeß des Verfahrens unterzogen, in welchem innerhalb des Löschfensters LF die dünne Schicht des Löschoxyds Lo entsteht und außerdem die bereits vorhandenen Oxydschichten Dox und Gox* verstärkt werden. Die noch vorhandenen Teile der ersten Oxydschicht Gox* werden auf diese Weise zur gewünschten Gateoxydschicht Gox1 aufgewachsen. Der nun erreichte Zustand ist in Fig. 6a und 6b gezeigt. Die Dicke des Löschoxyds Lo ist z. B. auf 20-30 nm, die Stärke des Gateoxyds Gox1 auf etwa 100-120 nm eingestellt.

Der nächste Schritt des erfindungsgemäßen Verfahrens besteht in der Abscheidung einer bevorzugt mit Phosphor dotierten ersten polykristallinen Siliciumschicht PS1 an der Oberfläche der bisher erhaltenen Anordnung gemäß Fig. 6a und 6b. Aus dieser Polysiliciumschicht PS1, die ganzflächig aufgebracht wird, wird zunächst, wie bereits oben ausgeführt, das schwebende Gate GF des ersten MOS-Feldeffekttransistors T1 durch maskierte Ätztechnik erzeugt.

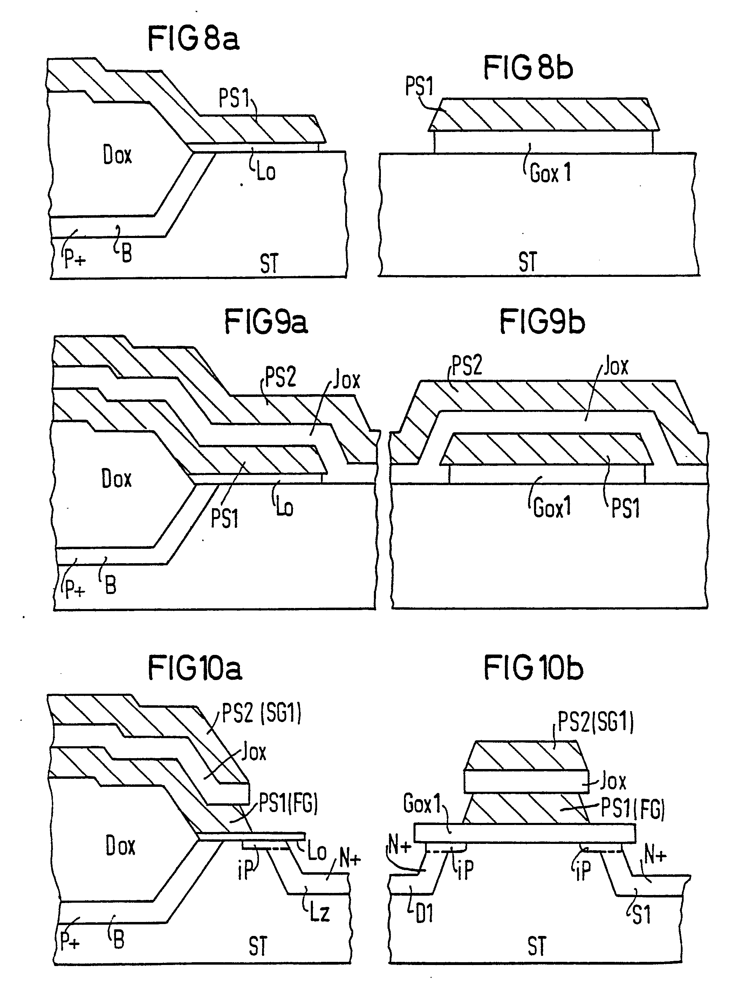

Die an der Oberfläche der nunmehr erhaltenen und aus Fig. 7a und 7b ersichtlichen Anordnung noch vorhandenen Teile der ersten polykristallinen Siliciumschicht PS1 decken diejenigen Teile des Gateoxyds Gox1 sowie des Löschoxyds Lo ab, die von dem nun folgenden Oxyd-Ätzprozeß nicht erfaßt werden sollen. Vor allem gilt dies für das den Kanalbereich KB des ersten MOS-Feldeffekttransistors T1 abdeckende Oxyd Gox1 sowie denjenigen Teil des Löschoxyd Lo, der den Löschteil des schwebenden Gates FG trägt. Der Ätzprozeß wird zweckmäßig mit einem das polykristalline Silicium im Gegensatz zum Oxyd nicht angreifenden Ätzmittel (z. B. wässriger HF-Lösung) unter Verwendung der an der Oberfläche der zu behandelnden Anordnung noch vorhandenen Teile der ersten polykristallinen Siliciumschicht PS1 als Ätzmaske oder durch Plasmaätzung durchgeführt. Das Resultat ist der aus Fig. 8a und Fig. 8b ersichtliche Zustand.

Es folgt ein weiterer Oxidationsschritt, der zur Entstehung des Isolationsoxyds Jox auf den noch vorhandenen Bereichen der ersten Polysiliciumschicht PS1 führt. Die dabei entstehende Oxydschicht ist dann die Gateoxydschicht Gox2 des zweiten Transistors T2. Dies ist für die Erzeugung des Gateoxyds Gox2 des zweiten MOS-Feldeffekttransistors T2 besonders günstig.

Die Isolationsoxydschicht Jox und das Gateoxyd Gox2 des zweiten Transistors werden nunmehr mit je einem aus polykristallinem Silicium bestehenden dotierten Steuergate SG1 bzw. SG2 versehen. Hierzu wird zunächst eine ebenfalls mit Phosphor dotierte polykristalline Siliciumschicht PS2 ganzflächig auf der Oberfläche der bisher erhaltenen Anordnung abgeschieden, was z. B. (ebenso wie die Abscheidung der ersten Polysiliciumschicht PS1) durch pyrolythische Zersetzung von $PH_3$-haltigem verdünnten $SiH_4$-Gas geschehen kann. Der nunmehr erhaltene Zustand der Anordnung ist aus Fig. 9a und 9b ersichtlich.

Als nächster Schritt erfolgt die Formung des Steuergates SG1 des ersten Transistors T1 und die gleichzeitige Formung des Steuergates SG2 des zweiten Transistors T2. Hierzu wird wiederum die bekannte Photolack-Ätztechnik angewendet. Dann werden die Oxydschichten Jox und Gox2 an den nicht von den Steuergates SG1 und SG2 der beiden Transistoren T1 und T2 abgedeckten Stellen durch ganzflächiges Überätzen mit einem Silicium nicht angreifenden Ätzmittel, z. B. mit verdünnter Flußsäure, von der Oberfläche der Anordnung entfernt. Schließlich wird unter Verwendung des (durch einen bei seiner Formung als Maske verwendeten Photolack-Überzug geschützten) Steuergates SG1 des ersten Transistors T1 als Ätzmaske das schwebende Gate FG des ersten Transistors in einem weiteren Polysilicium-Ätzprozeß aus dem noch am Ort des ersten Transistors T1 vorhandenen Bereich der ersten dotierten Polysiliciumschicht PS1 auf seine endgültige Form und Größe gebracht. Dieses selbstjustierende Ätzverfahren bei der Herstellung der beiden Gates SG1 und FG des ersten Transistors T1 dient zur Erzielung einer möglichst genauen Übereinstimmung der lateralen Geometrien der beiden Gates SG1 und FG des ersten MOS-Feldeffekttransistors T1.

Das die polykristalline Siliciumschicht PS1 bei der endgültigen Formung des schwebenden Gates FG formende Ätzmittel greift zwangsläufig auch die durch die Entfernung der die Grundlage des Gateoxyds Gox2 bildenden Oxydschicht von der Substratoberfläche freigelegten Stellen des aus monokristallinem Silicium bestehenden Substrats ST an, wie dies aus Fig. 10a und 10b ersichtlich ist. Beispielsweise gilt dies für diejenigen Stellen der Siliciumoberfläche, an denen noch die Source- und die Drainzonen der einzelnen Transistoren T1 und T2 der Speicherzellen zu erzeugen sind.

Als nächster Verfahrensschritt kommt eine ganzflächige Implantation der bisher behandelten Oberflächenseite der Anordnung mit einem Donator, z. B. Phosphor oder Arsen, wobei die Implantationsbedingungen derart eingestellt sind, daß sich lediglich an denjenigen Teilen der Oberfläche des einkristallinen Substrats ST Implantationszonen IP ausbilden können, die völlig unbedeckt oder lediglich mit einer Oxydschicht nicht hingegen aber mit der Kombination einer Oxydschicht mit einer Polysiliciumschicht PS1 bzw. PS2 abgedeckt sind. Damit bildet sich eine Implantationszone IP, wie aus Fig. 10a ersichtlich unmittelbar unter der freiliegenden Kante des Löschoxyds Lo sowie unterhalb der freiliegenden Ränder des Gateoxyds Gox1 (siehe Fig. 10b) aus. Außerdem entsteht eine solche Implantationszone vor allem auch an der Oberfläche der Source- und Draingebiete, nicht hingegen an der Oberfläche der Kanalgebiete KB der beiden Transistoren T1 und T2. Ggf. kann je eine solche Implantation die Aufgabe der Sourcezonen S1, S2, der Drainzonen D1, D2 sowie der Löschzone LZ im Löschbereich übernehmen.

Bevorzugt wird man jedoch unter Verwendung der Oxydschichten Lo und Gox1 (und Gox2) sowie der auf diesen aufgewachsenen Polysilgates als Diffusionsmasken die Dotierung der Source- und Draingebiete D1, S1, D2, S2 der beiden Transistoren und der Löschzone Lz der Speicherzelle durch einen anschließen- und in üblicher Weise durchzuführenden Diffusionsprozeß gemeinsam verstärken, so daß die Implantationszonen IP an den nichtoxydbedeckten Stellen der Substratoberfläche mit den dort entstehenden Diffusionsbereichen verschmelzen und die endgültigen Source- und Drainzonen der beiden Transistoren T1 und T2 sowie das endgültige Löschgebiet Lz bilden. Reste der Implantationszonen IP bleiben lediglich unter den nicht abgedeckten Rändern der Löschoxydschicht Lo und der Gateoxydschichten Gox1 und Gox2 erhalten. Voraussetzung hierfür ist jedoch, daß die Diffusionstiefe der Diffusionszonen in entsprechender Weise auf die laterale Geometrie der Implantationszonen IP abgestimmt wird. Auf den letzten Diffusionsprozeß kann, wie angedeutet, dann verzichtet werden, wenn bereits aufgrund des vorangegangenen Implantationsprozesses ein ausreichend niedriger Schichtwiderstand im Source-Drainbereich der beiden Transistoren T1 und T2 und im Löschgebiet Lz erreicht wurde.

Unter Verwendung der hierzu üblichen Methoden erfolgt nun die Herstellung des die oberste Oxydschicht Zox bildenden Abdeckoxyds (z. B. durch Aufsputtern). In dieser Oxydschicht Zox werden dann an den hierfür vorgesehenen Stellen die zu den einzelnen Kontaktierungsstellen an Source und Drain der beiden Transistoren T1 und T2 und die zu den Kontaktstellen ihrer Steuergates SG1 bzw. SG2 führenden Kontaktöffnungen geätzt und die entsprechenden, insbesondere aus Aluminium bestehenden Anschlüsse, also auch die Anschlüsse A1, A2, A3 (vgl. Fig. 1 bis 3) in üblicher Weise erzeugt. Die Anschlüsse können mit der Verbindung zwischen den einzelnen Speicherzellen dienenden Leiterbahnen zusammenfallen. In Fig. 10a und in Fig. 10b ist der längs der Linien II-II' bzw. I-I' erreichte Zustand, wie er unmittelbar nach dem letzten Diffusionsprozeß und vor der äußeren Oxydschicht Zox vorliegt, dargestellt. Das Feldexyd Dox ist in den Figuren 6b, 7b, 8b, 9b und 10b nicht dargestellt. Die Figuren 10a und 10b zeigen deutlich, daß gleichzeitig mit der endgültigen Formung des schwebenden Gates FG auch eine Abtragung der freiliegenden Stellen der Substratoberfläche erfolgt ist, während die oxydbedeckten Teile der Substratoberfläche lediglich am Rande etwas unterätzt sind.

Das anhand der Figuren 4 bis 10b beschriebene Verfahren stellt eine besonders vorteilhafte Ausgestaltung der Erfindung dar. Aufgrund der mit dem Verfahren verbundenen Vermeidung von sog. Oxyd-Hohlkehlen unter den Kanten des schwebenden Gates FG und des Steuergates SG1 des ersten Transistor T1 der Speicherzelle führt diese Ausgestaltung des erfindungsgemäßen Verfahrens nicht nur zu einer Verbesserung der Qualität der gesamten Oxydisolation der Speicherzelle sondern vor allem auch zu einer deutlichen Erhöhung der der betreffenden Speicherzelle zumutbaren Anzahl von Löschzyklen und damit der Lebensdauer der Speicherzelle.

Die elektrische Löschung des in der Speicherzelle gespeicherten Informationsgehaltes läßt sich aufgrund der Anwendung des erfindungsgemäßen Verfahrens bei der Erzeugung der Speicherzelle durch sehr niedrige Tunnelströme erreichen. Daher ist die Höhe des Schichtwiderstandes des implantierten Bereiches IP im Löschbereich der Speicherzelle relativ unkritisch. Hingegen hängt das Programmierverhalten der Speicherzelle empfindlich vom Schichtwiderstand der Source-Drain-Anschlußbereiche des ersten Transistors T1 der Speicherzelle ab.

Sollte daher der Schichtwiderstand der Source-Drain-Anschlußbereiche des ersten Transistors T1 der Speicherzelle einer zusätzlichen Erniedrigung bedürfen, so empfiehlt es sich, die über das schwebende Gate FG des ersten Transistors T1 der Speicherzelle hinausragenden Teile des Gateoxyds Gox1 unter Verwendung eines weiteren Maskenschrittes zum Schutze des Löschbereiches wegzuätzen und die Source- und Draingebiete S1, D1 an den Rand des Steuergates SG1 und des schwebenden Gates FG des Transistors T1 heranzuziehen.

**Patentansprüche**

1. Verfahren zum Herstellen einer monolithisch integrierten Zwei-Transistor-Speicherzelle in .MOS-Technik,
wobei die herzustellende Speicherzelle folgende Merkmale aufweist :
— einen ersten MOS-Feldeffekttransistor zur Informationsspeicherung mit einem Steuergate und einem schwebenden Gate,
— das schwebende Gate ist zwischen dem Steuergate und der Oberfläche des die Speicherzelle aufnehmenden Siliziumkristalls angeordnet,
— einen zweiten MOS-Feldeffekttransistor mit einem Steuergate,
— die Steuergates und das schwebende Gate sind aus dotiertem polykristallinem Silizium durch maskierte Ätztechnik geformt,
— die Steuergates und das schwebende Gate sind jeweils auf einer SiO$_2$-Schicht angeordnet,
— für das schwebende Gate ist abseits des stromführenden Kanals des ersten MOS-Feldeffekttransistors ein Löschbereich angeordnet,
und wobei das Herstellungsverfahren folgende Merkmale aufweist :
— Die Oberfläche des Siliziumkristalls (ST) wird durch thermische Oxidation mit einer einen Teil des Gateoxids (Gox1) des ersten MOS-Feldeffekttransistors (T1) bildenden ersten SiO$_2$-Schicht (Gox*) abgedeckt,
— in der ersten SiO$_2$-Schicht (Gox*) wird für den Löschbereich (Lz) ein bis zur Oberfläche des Siliziumkristalls (ST) durchgehendes Löschfenster (LF) erzeugt,
— in einem weiteren Oxidationsprozeß werden sowohl die im Löschfenster (LF) als Löschbereich (Lz) freiliegende Oberfläche des Siliziumkristalls (ST) erneut oxidiert als auch gleichzeitig die noch vorhandenen Teile der ersten SiO$_2$-Schicht (Gox*) bis zur geplanten Gesamtdicke des Gateoxids (Gox1) aufoxidiert,
— auf das Gateoxid (Gox1) und die im Löschfenster (LF) am Löschbereich (Lz) zuletzt erzeugte SiO$_2$-Schicht (Lo) wird eine erste Schicht (PS1) aus dotiertem polykristallinem Silizium abgeschieden als Material für das zu erzeugende schwebende Gate (FG) des ersten MOS-Feldeffekttransistors (T1),
— die erste Schicht polykristallinen Siliziums (PS1) wird an den Orten der Source- und Drainbereiche des ersten MOS-Feldeffekttransistors (T1) sowie an einer zu dem künftigen schwebenden Gate (FG) abgewandten Kante des Löschfensters (LF) des Löschbereichs (Lz) durch Ätzmittel wieder entfernt, wobei die erste Schicht (PS1) mindestens am Ort des künftigen schwebenden Gates (FG) erhalten bleibt,
— der so verbliebene Rest der ersten Schicht polykristallinen Siliziums (PS1) wird wenigstens in dem Teil, der das schwebende Gate (FG) bildet, mit einer weiteren SiO$_2$-Schicht (Jox) abgedeckt, gekennzeichnet durch folgende Verfahrensschritte :
— Nach dem Entfernen von Teilen des polykristallinen Siliziums (PS1) im Bereich des ersten MOS-Feldeffekttransistors (T1) werden die so freigelegten Stellen der Oxidschicht (Gox1) von der Oberfläche des Siliziumkristalls (ST) entfernt,
— ebenso werden die erste Schicht polykristallinen Siliziums (PS1) und die diese tragende Oxidschicht (Gox1) im Bereich des zweiten MOS-Feldeffekttransistors (T2) entfernt, um Gateoxid und Steuergate des zweiten MOS-Feldeffekttransistors (T2) in an sich bekannten Schritten gemeinsam mit dem Steuergate (SG1) des ersten MOS-Feldeffekttransistors (T1) herstellen zu können.

2. Verfahren nach Anspruch 1 dadurch gekennzeichnet, daß an den unmittelbar nach der Erzeugung der ersten polykristallinen Siliziumschicht (PS1) wieder freigelegten Stellen der Oberfläche des Siliciumkristalls (ST) sowie an der Oberfläche der noch vorhandenen Teile der ersten polykristallinen Siliciumschicht (PS1) durch einen gemeinsamen Oxidationsprozeß eine zusammenhängende Oxidschicht (Jox, Gox2) erzeugt und auf dieser die die Grundlage des Steuergates (SG1) des ersten MOS-Feldeffekttransistors (T1) und des Steuergates (SG2) des zweiten MOS-Feldeffekttransistors (T2) bildende zweite polykristalline Siliciumschicht (PS2) abgeschieden wird.

3. Verfahren nach Anspruch 2, dadurch gekennzeichnet, daß zunächst aus der zweiten polykristallinen Siliciumschicht (PS2) das Steuergate (SG1) des ersten MOS-Feldeffekttransistors (T1) und auch das Steuergate (SG2) des zweiten Transistors (T2) durch maskiertes Ätzen geformt und daß dann das Steuergate (SG1) des ersten MOS-Feldeffekttransistors (T1) bzw. die dieses abdeckende Ätzmaske für die Formung des schwebenden Gates (FG) aus der ersten polykristallinen Siliciumschicht (PS1) verwendet wird.

4. Verfahren nach einem der Ansprüche 1 bis 3, dadurch gekennzeichnet, daß die unmittelbar nach der Formung des schwebenden Gates (FG) des ersten Transistors (T1) sich unterhalb des schwebenden Gates (FG) befindende Oxidschicht (Gox1, Lo) zwecks Vermeidung von Oxidhohlkehlen nicht weiter abgetragen sondern unverändert beibehalten wird.

5. Verfahren nach einem der Ansprüche 1 bis 4, dadurch gekennzeichnet, daß wenigstens am Ort des ersten Transistors (T1) im Anschluß an die Erzeugung der Gates der beiden Transistoren (T1, T2) eine Implantationsbehandlung mit einem den Leitungstyp der Source- und Drainzone der beiden MOS-Feldeffekttransistoren (T1, T2) erzeugenden Dotierungsstoff vorgesehen und dabei die Implantationsbedingungen derart eingestellt werden, daß die auftreffenden Ionen des zu implantierenden Dotierungsstoffes nur dort in den Siliciumkristall (ST) gelangen, wo dieser nicht aus einer Kombination einer Oxidschicht und einer polykristallinen Siliciumschicht sondern höchstens nur mit einer Oxidschicht abgedeckt ist.

6. Verfahren nach Anspruch 5, dadurch gekennzeichnet, daß an den bei der Implantation unbedeckten Stellen der Oberfläche des Siliciumkristalls (ST) eine lediglich auf diese Stellen beschränkte Diffusionbehandlung mit einem denselben Leitungstyp wie die Implantation erzeugenden Dotierungsstoff im Anschluß an die Implantation vorgenommen wird.

**Claims**

1. A process for the production of a monolithic integrated two-transistor storage cell in MOS-technology,
where the storage cell to be produced displays the following features :
— a first MOS-field effect transistor for storage of information provided with a control gate and a floating gate,
— the floating gate is arranged between the control gate and the surface of the silicon crystal which receives the storage cell,
— a second MOS-field effect transistor provided with a control gate,
— the control gates and the floating gate are formed from doped polycrystalline silicon by a masked etching technique,
— the control gates and the floating gate are each arranged on an $SiO_2$-layer,
— an erasing region for the floating gate is arranged aside from the current-conducting channel of the first MOS-field effect transistor,
and where the production process comprises the following features :
— the surface of the silicon crystal (ST) is covered by thermal oxidation with a first $SiO_2$-layer (Gox*) which forms a part of the gate oxide layer (Gox1) of the first MOS-field effect transistor (T1),
— in the first $SiO_2$-layer (Gox*), an erasing window (LF) for the erasing zone (Lz) is formed, which window extends to the surface of the silicon crystal (ST),
— in a further oxidation step, the surface of the silicon crystal (ST) which is exposed as the erasing zone (Lz) in the erasing window (LF), is re-oxidised and simultaneously the parts of the first $SiO_2$-layer (Gox*) still present are oxidised to the planned overall thickness of the gate oxide layer (Gox1),
— a first layer (PS1) of doped polycrystalline silicon is deposited on the gate oxide layer (Gox1) and on the $SiO_2$-layer (Lo) last produced in the erasing window (LF) at the erasing zone (Lz), as material for the formation of the floating gate (FG) of the first MOS-field effect transistor (T1),
— at the locations of the source and drain zones of the first MOS-field effect transistor (T1) and at an edge of the erasing window (LF) at the erasing zone (Lz) facing away from the future floating gate zone (FG), the first layer of polycrystalline silicon (PS1) is removed again by an etching agent, the first layer (PS1) being retained at least at the location of the future floating gate (FG),
— the residue of the first layer of polycrystalline silicon (PS1) which thus remains is covered with a further $SiO_2$-layer (Jox), at least at that part which forms the floating gate (FG),
characterised by the following process steps :
— after the removal of parts of the polycrystalline silicon (PS1) in the region of the first MOS-field effect transistor (T1), those places on the oxide layer (Gox1) which have been exposed are removed from the surface of the silicon crystal (ST),
— the first layer of polycrystalline silicon (PS1) and the oxide layer (Gox1) which carries the latter in the region of the second MOS-field effect transistor (T2), are also removed to permit the formation of the gate oxide layer and of the control gate of the second MOS-field effect transistor (T2) by steps known per se, together with the control gate (SG1) of the first MOS-field effect transistor (T1).

2. A process as claimed in Claim 1, characterised in that at those places on the surface of the silicon crystal (ST) which have been exposed again immediately after the formation of the first polycrystalline silicon layer (PS1) and on the surface of the parts of the first polycrystalline silicon layer (PS1) still present, a cohesive oxide layer (Jox, Gox2) is formed by a common oxidation step, and the second polycrystalline silicon layer (PS2) which forms the basis of the control gate (SG1) of the first MOS-field effect transistor (T1) and of the control gate (SG2) of the second MOS-field effect transistor (T2) is deposited on to this oxide layer (Jox, Gox2).

3. A process as claimed in Claim 2, characterised in that first the control gate (SG1) of the first MOS-field effect transistor (T1) and the control gate (SG2) of the second transistor (T2) are formed from the second polycrystalline silicon layer (PS2) by masked etching, and that then the control gate (SG1) of the first MOS-field effect transistor (T1) and the etching mask which covers said control gate are used to form the floating gate (FG) from the first polycrystalline silicon layer (PS1).

4. A process as claimed in one of Claims 1 to 3, characterised in that, in order to avoid oxide hollows, the oxide layer (Gox1, Lo) which is located beneath the floating gate (FG) immediately after the formation of the floating gate (FG) of the first transistor (T1) is not further eroded but is retained unchanged.

5. A process as claimed in one of Claims 1 to 4, characterised in that at least at the location of the first transistor (T1), after the formation of the gates of the two transistors (T1, T2), an implantation treatment is provided using a dopant which produces the conductivity type of the source and drain zones of the two MOS-field effect transistors (T1, T2), the implantation conditions being set to be such that the incoming ions of the dopant which is to be implanted enter the silicon crystal (ST) only at those locations at which the silicon crystal is covered, not by a combination of an oxide layer and a polycrystalline silicon layer, but at most only by an oxide layer.

6. A process as claimed in Claim 5, characterised in that at those places on the surface of the silicon crystal (ST) which are not covered during the implantation, a diffusion treatment, confined only to these places, is carried out after the implantation, using a dopant which produces the same conductivity type as the implantation.

## Revendications

1. Procédé pour fabriquer une cellule de mémoire intégrée monolithique à deux transistors selon la technique MOS,
selon lequel la cellule de mémoire devant être fabriquée présente les caractéristiques suivantes :
— un premier transistor à effet de champ MOS servant à mémoriser l'information et comportant une grille de commande et une grille flottante,
— la grille flottante est disposée entre la grille de commande et la surface du cristal de silicium recevant la cellule de mémoire,
— un second transistor à effet de champ MOS comportant une grille de commande,
— la grille de commande et la grille flottante sont réalisées, à l'aide d'une technique de corrosion avec masquage, à partir de silicium polycristallin dopé,
— la grille de commande et la grille flottante sont disposées respectivement sur une couche de $SiO_2$,
— pour la grille flottante, il est prévu une zone d'effacement disposée à l'écart du canal, véhiculant le courant, du premier transistor à effet de champ MOS,
et selon lequel le procédé de fabrication présente les caractéristiques suivantes :
— la surface du cristal de silicium (ST) est recouverte, par oxydation thermique, par une première couche de $SiO_2$ (Gox*) constituant une partie de l'oxyde de grille (Gox1) du premier transistor à effet de champ MOS (T1),
— dans la première couche de $SiO_2$ (Gox*), on ménage, pour la zone d'effacement (Lz), une fenêtre d'effacement (LF) qui s'étend de façon continue jusqu'à la surface du cristal de silicium (ST),
— au cours d'une opération ultérieure d'oxydation, d'une part on oxyde à nouveau la surface du cristal de silicium (ST), qui est à nu dans la fenêtre d'effacement (LF) en tant que zone d'effacement (Lz), et d'autre part on oxyde simultanément les parties encore restantes de la première couche de $SiO_2$ (Gox*) jusqu'à ce que soit atteinte l'épaisseur globale désirée pour l'oxyde de grille (Gox1),
— sur l'oxyde de grille (Gox1) et sur la couche de $SiO_2$(Lo) produite en dernier lieu dans la fenêtre d'effacement (Lf) au niveau de la zone d'effacement (Lz), on dépose une première couche (PS1) formée de silicium polycristallin dopé en tant que matériau constitutif de la grille flottante (FG), qui doit être formée, du premier transistor à effet de champ MOS (T1),
— on élimine à nouveau la première couche de silicium polycristallin (PS1), aux emplacements des régions de source et de drain du premier transistor à effet de champ MOS (T1) ainsi qu'au niveau d'un bord, écarté de la grille flottante (FG) formée ultérieurement, de la fenêtre d'effacement (LF) de la zone d'effacement (Lz), en utilisant un agent corrosif, la première couche (PS1) subsistant au moins à l'emplacement de la grille flottante (FG) formée ultérieurement,
— on recouvre par une autre couche de $SiO_2$ (Jox) le reste alors obtenu de la première couche de silicium polycristallin (PS1), au moins dans la partie formant la grille flottante (FG),
caractérisé par les étapes opératoires suivantes :
— après l'élimination de parties du silicium polycristallin (PS1) dans la région du premier transistor à effet de champ MOS (T1), on élimine les zones ainsi libérées de la couche d'oxyde (Gox1), de la surface du cristal de silicium (ST),
— de même, on élimine la première couche de silicium polycristallin (PS1) et la couche d'oxyde (Gox1), portant la couche précédente, dans la région du second transistor à effet de champ MOS (T2), afin de pouvoir fabriquer l'oxyde de grille et la grille de commande du second transistor à effet de champ (T2), selon des étapes opératoires connues en soi, en commun avec la grille de commande (FG1) du premier transistor à effet de champ MOS (T1).

2. Procédé suivant la revendication 1, caractérisé par le fait qu'aux emplacements de la surface du cristal de silicium (ST), à nouveau mis à nu, directement après la formation de la première couche de silicium polycristallin (PS1), ainsi que sur la surface des parties encore présentes de la première couche de silicium polycristallin (PS1), on forme, au moyen d'un processus commun d'oxydation, une couche d'oxyde continue (Jox, Gox2) et on dépose sur cette couche, la seconde couche de silicium polycristallin (PS2) qui constitue la couche de base pour la grille de commande (SG) du premier transistor à effet de champ MOS (T1) et de la grille de commande (SG2) du second transistor à effet de champ MOS (T2).

3. Procédé suivant la revendication 2, caractérisé par le fait qu'on forme tout d'abord, par corrosion avec masquage, à partir de la seconde couche de silicium polycristallin (PS2), la grille de commande (SG1) du premier transistor à effet de champ MOS (T1) et également la grille de commande (SG2) du second transistor (T2), et qu'on utilise ensuite la grille de commande (SG1) du premier transistor à effet de champ MOS (T1) et le masque de corrosion, recouvrant cette grille, pour former la grille flottante (FG) à partir de la première couche de silicium polycristallin (PS1).

4. Procédé suivant l'une des revendications 1 à 3, caractérisé par le fait qu'on n'élimine pas à nouveau, mais qu'on conserve à l'état non modifié la couche d'oxyde (Gox1, Lo) située au-dessous de la grille flottante (FG) du premier transistor (T1), aussitôt après la formation de cette grille, afin d'éviter l'apparition de cavités dans l'oxyde.

5. Procédé suivant l'une des revendications 1 à 4, caractérisé par le fait qu'au moins à l'emplacement du premier transistor (T1) on prévoit d'exécuter, à la suite de la formation des grilles des deux transistors (T1, T2), un traitement par implantation avec une substance dopante produisant le type de conductivité de la zone de source et de drain des deux transistors à effet de champ MOS (T1, T2), et on règle les conditions d'implantation de manière que les ions de la substance dopante à implanter, qui apparaissent, parviennent dans le cristal de silicium (ST) uniquement aux emplacements où ce dernier n'est pas recouvert par une combinaison d'une couche d'oxyde et d'une couche de silicium polycristallin, mais tout au plus uniquement par une couche d'oxyde.

6. Procédé suivant la revendication 5, caractérisé par le fait qu'aux emplacements, non recouverts lors de l'implantation, de la surface du cristal de silicium (ST), on exécute, à la suite de l'implantation, un traitement de diffusion, limité à ces seuls emplacements, avec le même type de conductivité que celui de la substance dopante fournissant l'implantation.

**FIG 1**

**FIG 2**

**FIG 3**

FIG 4

FIG5

FIG 6a

FIG 6b

FIG 7a

FIG 7b

FIG 8a

FIG 8b

FIG 9a

FIG 9b

FIG 10a

FIG 10b